**Europäisches Patentamt**

**European Patent Office**

**Office européen des brevets**

(19)

(11) Numéro de publication: **0 017 533**
**B1**

(12)

# FASCICULE DE BREVET EUROPEEN

(45) Date de publication du fascicule du brevet:
06.04.83

(51) Int. Cl.³: **H 03 H 9/36**

(21) Numéro de dépôt: **80400345.7**

(22) Date de dépôt: **14.03.80**

(54) **Ligne à retard électroacoustique à faible couplage direct.**

(30) Priorité: **29.03.79 FR 7907889**

(43) Date de publication de la demande:
**15.10.80 Bulletin 80/21**

(45) Mention de la délivrance du brevet:
**06.04.83 Bulletin 83/14**

(84) Etats contractants désignés:
**BE DE GB IT NL**

(56) Documents cités:
**DE-A-1 616 415**
**FR-A-2 094 443**
**FR-A-2 239 812**
**FR-A-2 241 166**

**IEEE TRANSACTIONS ON MICROWAVE THEORY AND TECHNIQUES, vol. MTT 17, no. 11, novembre 1969 New York US F.S. HICKERNELL: «Piezoelectric semiconductor acoustic delay lines» pages 957–963**

(73) Titulaire: **THOMSON-CSF, 173, Boulevard Haussmann, F-75379 Paris Cedex 08 (FR)**

(72) Inventeur: **Puyhaubert, Jean, "THOMSON-CSF" SCPI-173, Bld Haussmann, F-75360 Paris Cedex 08 (FR)**
Inventeur: **Jacquemin, Claude, "THOMSON-CSF" SCPI-173, Bld Haussmann, F-75360 Paris Cedex 08 (FR)**

(74) Mandataire: **Benoit, Monique et al, THOMSON-CSF SCPI 173, Bld Haussmann, F-75379 Paris Cedex 08 (FR)**

## Ligne à retard électro-acoustique à faible couplage direct

L'invention concerne les lignes à retard à ultrason fonctionnant en hyperfréquence.

De façon générale, une ligne à retard à ultrason est constituée par un milieu monocristallin, par exemple, un barreau de corindon, destiné à réaliser une ligne dont le retard est égal à quelques microsecondes en plaçant sur une première face terminale du barreau un transducteur d'entrée qui transforme le signal électrique en signal ultrasonore se propageant dans le barreau. Le transducteur de sortie peut être fixé soit sur la face terminale opposée du barreau, soit sur la même face terminale que le transducteur d'entrée. L'utilisation de réflexions multiples permet de réduire la longueur des barreaux dans des proportions considérables et de présenter les lignes à retard en boîtier normalisé par les fabricants de dispositifs à semi-conducteur.

Une ligne à retard disposée dans un boîtier normalisé de composant à semi-conducteur, et constituée par un milieu de propagation, un transducteur d'entrée fixé sur l'une des faces terminales du milieu, et un transducteur de sortie fixé sur la face terminale opposée, est décrite dans l'article publié dans la revue «IEEE Transactions on Microwave Theory and Techniques», vol. MTT 17, no 11, novembre 1969, pages 957 à 963, intitulé: «Piezoelectric semiconductor acoustic delay lines».

Il est également connu, en se reportant notamment aux brevets français FR-A-2 239 812 et FR-A-2 241 166 déposés par la demanderesse respectivement le 30 juillet 1973 et le 14 août 1973, de réaliser les faces réfléchissantes du milieu de propagation de l'onde acoustique de façon à assurer simultanément avec la réflexion, une focalisation de l'onde et une dispersion des points d'impact successifs sur la face réfléchissante. En associant à ce type de ligne un transducteur quasi-ponctuel du type décrit dans le brevet français FR-A-2 094 443 déposé le 22 juin 1970 par la demanderesse, on obtient des lignes à grand retard et à perte d'insertion relativement réduite sous un encombrement réduit par rapport à celui des lignes à réflexion unique.

La miniaturisation ainsi obtenue favorise le couplage direct entre le transducteur d'entrée et celui de sortie, de telle sorte que le transducteur de sortie délivre un premier signal direct de niveau compris entre celui du premier écho retardé et une valeur supérieure de 20 dB. Le but de la présente invention est de réduire l'intensité du signal transmis par couplage direct.

La ligne à retard électro-acoustique à réflexions multiples focalisées, selon l'invention, comportant un milieu de propagation de l'onde élastique, un transducteur d'entrée fixé sur l'une des faces terminales du milieu, et un transducteur de sortie fixé sur l'autre face terminale du milieu, la ligne étant disposée dans un boîtier, est caractérisée en ce qu'elle comporte également au moins un blindage en contact électrique avec le boîtier, ce blindage comprenant une coquille entourant sans contact le transducteur de sortie et sa connexion, la coquille étant collée à une pièce conductrice de fixation du milieu sur l'embase du boîtier, et la connexion du transducteur de sortie étant reliée à une broche maintenue à un potentiel fixe.

La ligne à retard selon l'invention présente les avantages suivants:

– le découplage entre les transducteurs d'entrée et de sortie permet d'utiliser systématiquement un écho de rang élevé, ce qui permet de limiter la longueur du cristal entre 8 et 10 millimètres même pour des retards de plusieurs microsecondes assurant une réduction de l'encombrement et du prix de la ligne;

– le blindage du transducteur de sortie, placé en une zone de focalisation de l'onde élastique, permet d'obtenir un signal de sortie supérieur de 10 dB à celui délivré par les lignes à retard à simple parcours sans focalisation et d'atténuer de plus de 40 dB le signal transmis par couplage direct, ce qui supprime la nécessité d'éliminer ce signal dans le circuit d'utilisation du signal retardé.

L'invention est décrite dans ce qui suit en référence aux figs. 1 à 5 données à titre illustratif, nullement limitatif dans lesquelles:

– la fig. 1 représente la coupe grossie d'une ligne à retard selon l'invention fonctionnant en transmission;

– la fig. 2 représente la plaquette de connexion d'entrée d'une ligne à retard selon la fig. 1;

– la fig. 3 représente la coupe du blindage du transducteur de sortie d'une ligne à retard selon la fig. 1;

– la fig. 4 représente partiellement une variante de réalisation relative à une ligne fonctionnant en réflexion;

– la fig. 5 représente une coupe partielle de la ligne à retard précédente.

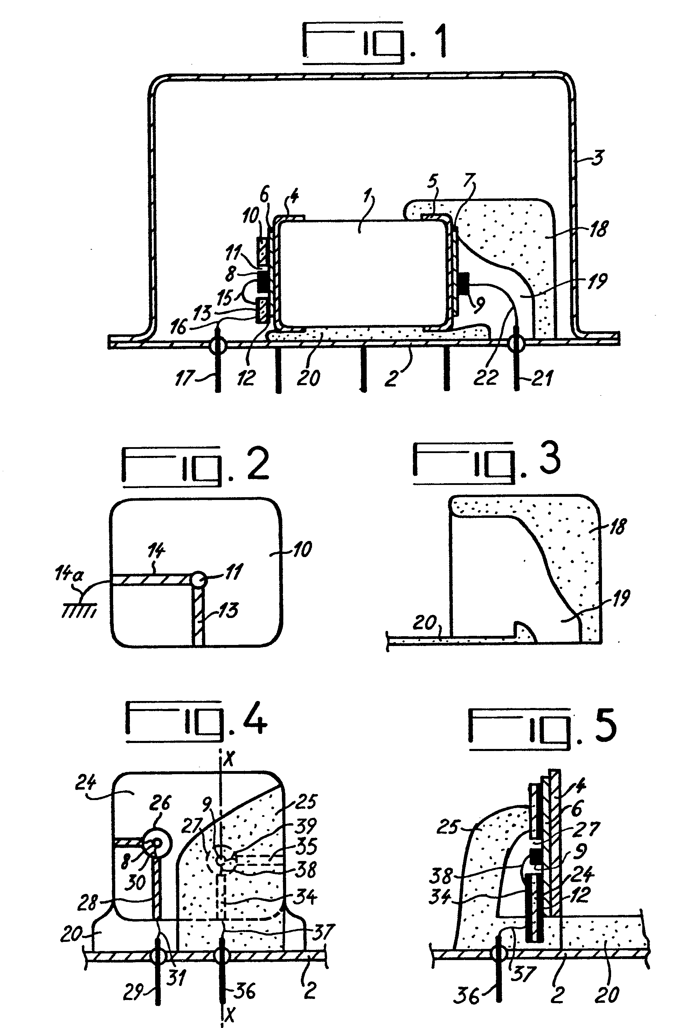

La fig. 1 représente une ligne à retard à réflexions multiples selon l'invention fonctionnant en transmission. Le cristal de corindon 1 est fixé sur l'embase 2 d'un boîtier normalisé pour dispositif à semi-conducteur, par exemple le boîtier T08 (12), fermé par le capot 3, à l'aide d'un berceau en matériau conducteur polymérisable 20 qui, de préférence, est solidaire d'une partie d'une coquille 18 assurant le blindage du transducteur de sorite 9 et de sa connexion 22. La connexion 22 est reliée à une broche 21 de l'embase 2 qui est maintenue à un potentiel fixe (masse générale par exemple). Il est possible de fixer le cristal sur toute sa longueur sans introduire d'atténuation de l'énergie acoustique, celle-ci étant guidée à l'intérieur du cristal par l'effet focalisant des faces réfléchissantes. Dans l'exemple représenté sur la fig. 1, les faces terminales du cristal 1, usinées en vue d'assurer une focalisation de l'onde réfléchie, sont recouvertes chacune d'une couche métallique respectivement 4 et 5, déposée par évaporation sous vide. Les couches 4 et 5 sont recouvertes d'une couche d'oxyde d'étain respectivement 6 et 7 jouant partiellement le rôle de transducteur. Des électrodes ponctuelles respectivement 8 et 9 placées sur les couches 6 et 7 complètent les transducteurs d'entrée et de sortie; elles sont réalisées ainsi qu'il est décrit dans le brevet 2 094 443. On désigne dans ce qui suit l'ensemble du transducteur par le repère de son électrode ponctuelle. Une plaquette isolante 10, percée en 11 et métallisée en 12 sur la totalité d'une face, porte sur la face opposée deux bandes conductrices rectilignes, dont une seule est représentée en 13 sur la fig. 1, disposées radialement autour du perçage 11, formant avec la métallisation 12 deux tronçons de ligne microbande d'impédance caractéristique égale à 50 ohms. La plaquette 10 est fixée sur le pourtour de la face métallisée 12 à la couche d'oxyde d'étain 6 par collage, de préférence à l'aide du même matériau polymérisable conducteur que celui utilisé à la fixation du cristal 1. La continuité électrique entre le berceau de fixation 20 et la face métallisée 12 est assurée par la colle.

La fig. 2 représente une vue de face de la plaquette 10. Le perçage 11 est effectué en fonction de la position désirée du transducteur 8 sur la face terminale et sa dimension est nettement supérieure à celle dudit transducteur. Les deux microbandes 13 et 14 sont disposées autour du perçage 11.

Comme il apparaît sur la fig. 1, la microbande 13 connectée à son extrémité inférieure à la broche 17 par le conducteur 16 sert de circuit d'entrée de la ligne à retard. L'autre extrémité de la microbande 13 est connectée au transducteur 8 par le conducteur 15. L'impédance du transducteur 8 est généralement plus basse que l'impédance normalisée (50 Ohms) qui doit être ramenée à l'entrée de la ligne. L'adaptation de l'impédance d'entrée est assurée à l'aide de la longueur de la microbande 13 associée éventuellement à des capacités localisées se présentant sous forme d'élargissements localisés de la métallisation ainsi qu'il est bien connu, en association avec une impédance d'adaptation constituée du tronçon de ligne microbande 14 (fig. 2) connecté à l'une de ses extrémités au transducteur 8 par un conducteur non représenté et à l'autre extrémité à la masse par un conducteur schématisé en 14a sur la fig. 2 de longueur appropriée. La masse est généralement un point de la métallisation 12.

Sur la fig. 1, la deuxième extrémité du cristal 1 portant le transducteur de sortie 9 est entourée d'un blindage 18 recouvrant la métallisation 5, le transducteur 9 et son conducteur 22. Ce blindage est constitué par une pièce massive conductrice réalisée en un matériau polymérisable susceptible d'adhérer à la pièce 20. De préférence, ces pièces sont constituées à partir d'une suspension d'argent dans l'araldite pâteuse vendue sous la référence H 20 E par la Société américaine EPO-TEK à Watertown (Mass.) et polymérisable à froid.

La fig. 3 représente la vue en coupe du blindage 18 qui est constitué de deux parties symétriques moulées séparément présentant chacune une gorge à section semi-circulaire 19. Une première moitié du blindage 18 est placée en appui sur la pièce 20 de fixation du cristal 1, la gorge 19 dégageant la face terminale au voisinage du transducteur 9 (fig. 1) et se terminant au voisinage de la broche 21. Le demi-blindage est alors fixé à l'embase 2 et à la pièce 20 par de l'araldite du type cité plus haut. Puis le conducteur 22 est mis en place de façon à relier le transducteur 9 à l'extrémité de la broche 21. L'adaptation de l'impédance de sortie est effectuée en utilisant un deuxième tronçon de ligne microbande connecté entre le transducteur 9 et le potentiel de référence par un conducteur de longueur adaptée. La deuxième partie du blindage 18, symétrique de celle représentée sur la fig. 3, est mise en place et fixée à son tour par de l'araldite déjà citée. En variante, l'ensemble de la partie 18 du blindage peut être moulé in situ, la gorge 19 étant délimitée avant application du matériau polymérisable.

A titre illustratif, la demanderesse réalise une ligne à retard équipée d'un blindage du type qui vient d'être décrit dans un boîtier du type T08 (12) dont les caractéristiques sont les suivantes:

— retard égal à 7 microsecondes, résultant de 9 parcours entre les faces terminales du cristal;
— longueur du cristal: 8 millimètres environ;
— bande passante à 3 dB comprise entre 1,2 et 1,8 GHz;
— perte d'insertion dans la bande inférieure à 32 dB;
— atténuation du signal direct entre l'entrée et la sortie égale à 70 db (entre les broches 17 et 21).

La fig. 4 représente en 24 une variante de réalisation de la plaquette 10 et en 25 une variante de réalisation du blindage 18, pour une ligne fonctionnant en réflexion. La plaquette 24 présente deux perçages 26 et 27 exécutés en fonction des positions respectives des transducteurs 8 et 9 sur la face terminale du cristal. Un tronçon de ligne microbande 28 aboutissant au perçage 26 permet de relier le transducteur 8 à l'aide des conducteurs 30 et 31 à la même broche 29 de l'embase 2. L'adaptation de l'impédance d'entrée utilise le tronçon de ligne 28 ainsi qu'il a été expliqué ci-dessus. Les deux tronçons de ligne microbande 34 et 35 aboutissent au perçage 27. Le tronçon 34 qui est vertical permet de réaliser la connexion du transducteur 9 à la broche 36 de l'embase 2 au moyen des conducteurs 37 et 38. Le tronçon horizontal 35 servant à l'adaptation de l'impédance de sortie est relié au transducteur 9 par le conducteur 39. Le blindage 25 est constitué d'une coquille fixée à sa partie inférieure sur l'embase 2 et appliquée sur la plaquette 24 au niveau du transducteur 9, la coquille séparant les deux perçages 26 et 27, de façon à constituer le blindage du transducteur 9.

La fig. 5 représente une coupe par le plan de trace XX de la fig. 4, les couches 4, 6 et 12 de la fig. 1 étant également représentées. Ainsi qu'il apparaît, la coquille 25 revient, au niveau de sa partie inférieure, sur la partie droite en arrière de la plaquette 24 de façon à établir un contact avec la métallisation 12, la couche métallique 4 et la pièce 20 servant à la fixation du barreau 1 (non représenté) sur l'embase 2. La continuité électrique entre ces différents éléments conducteurs est assurée par utilisation d'une colle conductrice. Comme dans la variante précédente, la coquille 25 peut être réalisée à partir de deux demi-coquilles moulées collées ensemble à l'aide d'une colle conductrice. La forme de la coquille est choisie pour dégager les perçages 26 et 27 et enfermer le transducteur 9 et sa connexion de sortie ainsi que le tronçon servant à l'adaptation. Certains conducteurs se trouvent enrobés dans la coquille lorsque celle-ci est moulée et polymérisée in situ, le conducteur 37 par exemple. Comme dans la variante précédente, la pièce conductrice 20 de fixation du cristal à l'embase 2 est en contact avec une broche maintenue à un potentiel fixe.

A titre illustratif, la demanderesse réalise une ligne à retard opérant en réflexion, présentant les caractéristiques suivantes:
  – retard égal à 2,8 microsecondes résultant de 4 parcours entre les faces terminales du cristal;
    – longueur du cristal: 8 millimètres environ;
    – bande passante à 3 dB comprise entre 1,4 et 2,5 GHz;
    – perte d'insertion égale à 35 dB au milieu de la bande passante;
    – atténuation du signal direct égale à 60 dB (entre les broches 29 et 36);
    – atténuation sans blindage égale à 20 dB.

## Revendications

1. Ligne à retard électro-acoustique à réflexions multiples focalisées comportant un milieu de propagation (1) de l'onde élastique, un transducteur d'entrée (6, 8) fixé sur l'une des faces terminales du milieu (1), et un transducteur de sortie (7, 9) fixé sur l'autre face terminale du milieu (1), la ligne étant disposée dans un boîtier (3), caractérisée en ce que la ligne comporte également au moins un blindage en contact électrique avec le boîtier (3), ce blindage comprenant une coquille (18) entourant sans contact le transducteur de sortie (7, 9) et sa connexion (22), la coquille étant collée à une pièce conductrice de fixation (20) du milieu (1) sur l'embase (2) du boîtier, et la connexion du transducteur de sortie étant reliée à une broche (21) maintenue à un potentiel fixe.

2. Ligne à retard selon la revendication 1, caractérisée en ce que le blindage (18) est obtenu par moulage d'une matière polymérisable rendue conductrice par une charge métallique.

3. Ligne à retard selon l'une des revendications 1 et 2, caractérisée en ce que le blindage (18) est fixé à l'une des faces terminales du milieu (1) et mis en contact électrique avec la pièce de fixation (20) par collage à l'aide d'une colle conductrice.

4. Ligne à retard selon la revendication 1, caractérisée en ce que le blindage (18) comporte plusieurs parties collées ensemble à l'aide d'une colle conductrice.

5. Ligne à retard selon la revendication 1, caractérisée en ce que le collage de la coquille (18) avec la pièce de fixation (20) est assuré par le matériau servant à constituer la coquille (18).

## Claims

1. An electroacoustic delay line with multiple focussed reflections, comprising a medium (1) within which the elastic wave is propagated, an input transducer (6, 8) attached to one of the end surfaces of the medium (1), and an output transducer (7, 9) attached to the other end surface of the medium (1), this line being placed in a casing (3), characterized by the fact that the line further comprises at least one shielding device in electrical contact with the casing (3), this shielding device comprising a shell (18) surrounding the output transducer (7, 9) and its connection (22) while not being in contact with them, this cover being glued to a conductive fixing component (20) joining the medium (1) to the base (2) of the casing, and the output transducer connection being attached to a pin (21) which is kept at a fixed potential.

2. A delay line as defined in claim 1, characterized by the fact that the shielding means (18) is obtained by moulding a polymerizable material, which is rendered conductive by the addition of a metal filler.

3. A delay line as defined in either of claims 1 or 2, characterized by the fact that the shielding means (18) is attached to one of the end surfaces of the medium (1), and electrically connected to the fixing component (20) by means of a conductive glue.

4. A delay line as defined in claim 1, characterized by the fact that the shielding means (18) comprises a number of parts, glued to each other by means of a conductive glue.

5. A delay line as defined in claim 1, characterized by the fact that the shell (18) is glued to the fixing component (20) by use of the material used to form the shell.

## Patentansprüche

1. Elektroakustische Verzögerungsstrecke mit gebündelter Mehrfachreflexion, die ein Fortpflanzungsmedium (1) für die elastische Welle, einen auf einer der Endflächen des Mediums (1) befestigten Eingangstransduktor (6, 8), sowie einen auf der anderen Endfläche des Mediums (1) befestigten Ausgangstransduktor (7, 9) aufweist, wobei die Strecke in einem Gehäuse (3) angeordnet ist, dadurch gekennzeichnet, dass die Strecke ferner wenigstens eine mit dem Gehäuse (3) elektrisch verbundene Abschirmung aufweist, die eine den Ausgangstransduktor (7, 9) und dessen Anschluss (22) ohne Kontakt umgebende Schale (18) besitzt, die durch Kleben mit einem leitenden Befestigungsteil (20) des Mediums (1) auf der Basis (2) des Gehäuses verbunden ist, während der Ausgangsanschluss des Transduktors mit einer unter einem unveränderlichen Potential stehenden Spindel (21) verbunden ist.

2. Verzögerungsstrecke nach Anspruch 1, dadurch gekennzeichnet, dass die Abschirmung (18) durch Formen eines vermittels eines metallischen Füllmaterials leitend gemachten polymerisierbaren Stoffes gefertigt ist.

3. Verzögerungsstrecke nach Anspruch 1 oder 2, dadurch gekennzeichnet, dass die Abschirmung (18) an einer der Endflächen des Mediums (1) befestigt ist und elektrisch durch Kleben vermittels eines leitfähigen Klebemittels mit dem Befestigungsteil (20) verbunden ist.

4. Verzögerungsstrecke nach Anspruch 1, dadurch gekennzeichnet, dass die Abschirmung (18) mehrere durch Kleben vermittels eines leitfähigen Klebemittels miteinander verbundene Teile aufweist.

5. Verzögerungsstrecke nach Anspruch 1, dadurch gekennzeichnet, dass die Klebeverbindung zwischen der Schale (18) und dem Befestigungsteil (20) vermittels des die Schale (18) bildenden Stoffes hergestellt ist.

0 017 533

Fig. 1

Fig. 2

Fig. 3

Fig. 4

Fig. 5

7